(19) **Europäisches Patentamt / European Patent Office / Office européen des brevets**

(11) **EP 4 624 959 A1**

(12) **EUROPEAN PATENT APPLICATION**

(43) Date of publication:
01.10.2025 Bulletin 2025/40

(21) Application number: 25165829.0

(22) Date of filing: 25.03.2025

(51) International Patent Classification (IPC):
$G01R\ 31/389^{(2019.01)}$ $G01R\ 31/392^{(2019.01)}$

(52) Cooperative Patent Classification (CPC):
G01R 31/389; G01R 31/392; H01M 10/48;
G01R 31/382; H01M 2220/20

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 29.03.2024 CN 202410384689

(71) Applicant: Volvo Car Corporation
405 31 Göteborg (SE)

(72) Inventors:
• SHEN, Bin
  Shanghai (CN)
• WANG, Yang
  Shanghai (CN)
• LU, Huapeng
  Shanghai (CN)
• HE, Wuliyasu
  Shanghai (CN)
• KE, Peng
  Shanghai (CN)

(74) Representative: Maiwald GmbH
Engineering
Elisenhof
Elisenstrasse 3
80335 München (DE)

(54) **METHOD, APPARATUS AND SYSTEM FOR LI-PLATING DETECTION OF POWER BATTERY**

(57) The present disclosure relates to a computer-implemented method for Li-plating detection of a cell of a power battery. The method includes: obtaining a plurality of AC impedance values for the cell measured at a plurality of States of Charge (SOCs), in which the plurality of AC impedance values are measured in a non-driving state of a vehicle; fitting the AC impedance values as a function of SOC based on the plurality of AC impedance values; and calculating a goodness of fit for the function, and calculating a Li-plating score for the cell based on the goodness of fit, in which the Li-plating score is used to indicate a degree to which Li-plating occurs in the cell.

**100**

| | |
|---|---|
| S101 | Obtaining a plurality of AC impedance values for the cell measured at a plurality of SOCs |
| S102 | Fitting the AC impedance values as a function of SOC based on the plurality of AC impedance values measured at the plurality of SOCs |
| S103 | Calculating a goodness of fit for the AC impedance values as a function of SOCs, and calculating a Li-plating score for the cell based on the goodness of fit |

Fig. 1

## Description

## TECHNICAL FIELD

The present disclosure relates to the field of electric vehicles, and more specifically, to a method, apparatus, and system for lithium plating (Li-plating) detection of a power battery.

## BACKGROUND

In recent years, the industry of new energy vehicles has risen rapidly, and electric vehicles are favored by consumers because of their advantages such as energy savings, high efficiency, low carbon, environmental friendliness, and the like. With the wide use of electric vehicles, technologies for on-board power batteries have been paid more and more attention. At present, power batteries for electric vehicles are mostly Li-ion batteries, such as lithium iron phosphate batteries and ternary lithium batteries. Such batteries have advantages such as high energy density, a wide range of operating temperatures, long storage life, and the like.

For a Li-ion battery, during its charging and discharging, Li-ions in the battery may pass through a diaphragm and go back and forth between positive and negative electrodes. During the charging, the Li-ions are deintercalated from the positive electrode, and intercalated into the negative electrode via electrolyte; and then during the discharging, the Li-ions are deintercalated from the negative electrode, and recombined with a compound of the positive electrode. However, in a scenario such as charging in a low-temperature environment or fast charging, a Li-plating phenomenon of the Li-ion battery might be incurred, i.e., the Li-ions deintercalated from the positive electrode cannot be intercalated into the negative electrode, leading such Li-ions to be plated out at the negative electrode, forming a layer of metallic lithium. The Li-plating will cause a reduction in the Li-ions in the Li-ion battery, leading to problems such as energy reduction, shortened service life, and the like for the power battery, and will further generate Lithium dendrite at the negative electrode, puncturing the diaphragm to cause a short circuit in the battery, in turn incurring serious safety hazards. Therefore, it is crucial for the use experience and safety of the electric vehicles to perform a Li-plating detection of a power battery.

Since a Li-ion battery typically has a sealed outer package, it is not easy to detect whether Li-plating occurs. Therefore, there is a need for a non-destructive method for Li-plating detection. However, some existing methods for Li-plating detection often require charging and discharging the battery thoroughly in a laboratory environment, with very complicated algorithms and poor applicability.

## SUMMARY

In view of this, the present disclosure proposes an improved method for Li-plating detection, which utilizes impedance data measured for a vehicle in a non-driving state to calculate, in a relatively simple manner, a score indicating a degree to which Li-plating occurs in a cell, with advantages such as simple and convenient calculation as well as wide applicability.

According to an aspect of the present disclosure, there is provided a computer-implemented method for Li-plating detection of a cell of a power battery. The method includes: obtaining a plurality of AC impedance values for the cell measured at a plurality of States of Charge (SOCs), in which the plurality of AC impedance values are measured in a non-driving state of a vehicle; fitting the AC impedance values as a function of SOC based on the plurality of AC impedance values; and calculating a goodness of fit for the function, and calculating a Li-plating score for the cell based on the goodness of fit, wherein the Li-plating score indicates a degree to which Li-plating occurs in the cell.

According to an embodiment of the present disclosure, the non-driving state includes: the vehicle being charged, the vehicle being discharged to an energy storage system, or the vehicle being parked with engine off.

According to an embodiment of the present disclosure, the non-driving state is the vehicle being charged or being discharged to the energy storage system, and the obtaining of the plurality of AC impedance values for the cell measured at the SOCs includes: suspending, during the charging or discharging of the vehicle, the charging/discharging at the plurality of different SOCs, and applying a plurality of AC pulses with different frequencies to the cell; and calculating, at each of the plurality of SOCs, an AC impedance value at a corresponding frequency according to a response by the cell to the plurality of AC pulses. Moreover, the plurality of AC pulses with different frequencies are provided by an external facility for offering charging or discharging of the vehicle.

According to an embodiment of the present disclosure, the non-driving state is the vehicle being parked with the engine shut off, and the obtaining of the plurality of AC impedance values for the cell measured at the SOCs includes: applying, when the vehicle is parked with engine off, a plurality of AC pulses with different frequencies to the cell at the plurality of different SOCs, in which the plurality of SOCs correspond to the SOCs when the vehicle is parked with engine off at different times; and calculating, at each of the plurality of SOCs, an AC impedance value at a corresponding frequency according to a response by the cell to the plurality of AC pulses. Moreover, the fitting of the AC impedance values as a function of SOC based on the plurality of AC impedance values includes: selecting, based on additional parameters, a first subset corresponding to a specific range of the additional parameters from the measured plurality of AC impedance values; and fitting, based on the first subset of the measured plurality of AC impedance values, the AC impedance values as a function of SOC, in which the additional parameters include: ambient temperature at the measurement, cell temperature at the measurement, and measurement time.

According to an embodiment of the present disclosure, the calculating the goodness of fit for the function and the calculating the Li-plating score for the cell based on the goodness of fit includes: calculating, for the function fitted based on the AC impedance values measured under each of the plurality of AC pulses, the goodness of fit for the function corresponding to each AC pulse; and calculating the Li-plating score for the cell based on the goodness of fit for the function corresponding to each AC pulse.

According to an embodiment of the present disclosure, the plurality of SOCs are uniformly distributed in a range spanning at least 50% of the SOCs, and/or the number of the plurality of SOCs is greater than or equal to 5.

According to another aspect of the present disclosure, there is provided an apparatus for Li-plating detection of a cell of a power battery. The apparatus includes a processor and a memory having stored computer program instructions therein, in which the computer program instructions, when executed by the processor, cause the apparatus to perform the above method for Li-plating detection of a cell of a power battery.

According to yet another aspect of the present disclosure, there is provided a computer-readable storage medium having stored computer program instructions thereon, and there is provided a computer program product including computer program instructions, in which the computer program instructions, when executed by a processor, cause the processor to perform the above method for Li-plating detection of a cell of a power battery.

According to yet another aspect of the present disclosure, there is provided a system for Li-plating detection of a cell of a power battery. The system includes: an energy exchange facility, for offering charging and/or discharging services to a vehicle; and a Li-plating detection module, communicably connected with the energy exchange facility; in which the energy exchange facility is configured to: suspend, during the charging or discharging of the vehicle, the charging/discharging at different States of Charge (SOCs), and apply a plurality of AC pulses with different frequencies to the cell; and provide the plurality of AC impedance values measured at the plurality of SOCs to the Li-plating detection module, in which the plurality of AC impedance values are calculated, at each of the plurality of SOCs, according to a response by the cell to the plurality of AC pulses; and the Li-plating detection module is configured to: fit the AC impedance values as a function of SOC based on the plurality of AC impedance values; and calculate a goodness of fit for the function, and calculate a Li-plating score for the cell based on the goodness of fit, wherein the Li-plating score indicates a degree to which Li-plating occurs in the cell.

According to yet another aspect of the present disclosure, there is provided a vehicle comprising a power battery including at least one cell; and an impedance measuring module is configured to obtain a plurality of AC impedance values for one of the at least one cell measured at a plurality of States of Charge (SOCs), wherein the plurality of AC impedance values are measured in a non-driving state of the vehicle; and provide the plurality of AC impedance values to an external apparatus for Li-plating detection of the cell of the power battery of the vehicle.

Based on the above, according to the method and apparatus for Li-plating detection of a power battery provided by the present disclosure, it is possible to utilize the non-use period of a vehicle, such as a period during which the vehicle is being charged or discharged, or even a regular parking period of the vehicle, to measure an impedance of a cell of a power battery and perform data fitting. Meanwhile, it is recognized in the present disclosure that there is an association between the goodness of fit for the AC impedance values of the cell and whether Li-plating occurs in the cell, on the basis of which there is proposed to calculate a Li-plating score for the cell based on the goodness of fit to indicate a degree to which Li-plating occurs in the cell. In this way, it is possible to, on the premise that the user's use of the vehicle is not affected, perform a non-destructive Li-plating detection on the cell in a simple and accurate manner.

On the other hand, the present disclosure further provides a system for Li-plating detection of a cell of a power battery. The system can not only provide charging/discharging services to the vehicle, but also incidentally detect, while charging/discharging the vehicle, whether Li-plating occurs in the cell of the current power battery of the vehicle.

**BRIEF DESCRIPTION OF DRAWINGS**

These and/or other aspects and advantages of the present disclosure will become clearer and easier to understand from the following detailed description of the embodiments of the present disclosure, taken in conjunction with the accompanying drawings, in which:

Fig. 1 is a flowchart showing a method for Li-plating detection of a cell of a power battery according to an embodiment of the present disclosure;
Fig. 2 is an example scenario showing Li-plating detection performed in a charging/discharging scenario according to an embodiment of the present disclosure;

Fig. 3 is another example scenario showing Li-plating detection performed in a parking scenario according to an embodiment of the present disclosure;

Fig. 4 is a block diagram showing a system for Li-plating detection of a cell of a power battery according to an embodiment of the present disclosure; and

Fig. 5 is a block diagram showing an apparatus for Li-plating detection of a cell of a power battery according to an embodiment of the present disclosure.

It should be understood that these accompanying drawings are used to provide a further understanding of the embodiments of the present disclosure and constitute a part of the specification, and together with the embodiments of the present disclosure, serve to interpret the technical solution of the present disclosure, rather than to constitute a limitation to the present disclosure. In addition, in the accompanying drawings, like reference numerals typically represent like parts or steps.

## DETAILED DESCRIPTION

In order to better set forth the technical solution of the present disclosure, a detailed illustration of the present disclosure is further made in conjunction with the accompanying drawings and the detailed description. It should be understood that based on the embodiments described in the present disclosure, all the other embodiments derived by those skilled in the art without paying creative labor should fall within the protection scope of the present disclosure, and the embodiments described herein are only part of the embodiments of the present disclosure, not all of the embodiments of the present disclosure. These embodiments are merely illustrative and exemplary, so they should not be interpreted as limiting the scope of the present disclosure.

Hereinafter, for the purpose of illustration rather than limitation, the present disclosure will mainly take a power battery of an electric vehicle as an example to set forth the technical solution of the present disclosure. The electric vehicle herein can broadly refer to a vehicle that at least partially uses an on-board power battery as power, which may include battery electric vehicle and hybrid electric vehicle, for example.

First of all, an illustration is made to the overall technical concept of the present disclosure and the involved terms.

A power battery is one of the core components of an electric vehicle and is responsible for storing and releasing electric energy to provide the vehicle with energy for driving and other vehicular applications, that is, the power battery serves as a power supply to the vehicle. The power battery is typically a battery pack composed of a plurality of cell monomers in series and/or in parallel. A State of Charge (SOC) of the power battery may be expressed as a ratio of the currently available remaining capacity of the power battery to its fully charged capacity, so in some scenarios, the SOC can also be simply regarded as the "remaining capacity" of the vehicle. In general, there is a certain correlation between the impedance of the cell and the SOC, so a function model about the impedance of the cell and the SOC (the impedance of the cell vs. the SOC) can be approximated by means of data fitting, and a goodness of fit may be used to evaluate a difference between the fitted function model and the actual data, to measure the interpretive capability and predictive accuracy of the function model to the actual data.

However, as described above, it is easy to incur the Li-plating phenomenon in a Li-ion battery in a scenario such as charging at a low temperature and fast charging, causing the metallic lithium to be plated out at the negative electrode of a single cell, correspondingly reducing the number of Li-ions in the power battery. It is recognized in the present disclosure that the true impedance of a cell will be affected by the Li-plating phenomenon, such that its correlation with the SOC changes, which in turn leads to a decline in the goodness of fit between the impedance of the cell and the SOC. In other words, the true impedance of a cell in which Li-plating occurs will significantly deviate from the corresponding fitted value, and in some sections of SOC, such a difference between the true impedance and the corresponding fitted value will be greater. Therefore, with this influence of the Li-plating phenomenon on the impedance of the cell, the present disclosure proposes to perform data fitting on the AC impedance values of the cell and calculate a Li-plating score for the cell based on the goodness of fit, to indicate a degree to which Li-plating occurs in the cell, thereby providing a simply and conveniently calculated method for Li-plating detection, without requiring thoroughly charging and discharging the power battery.

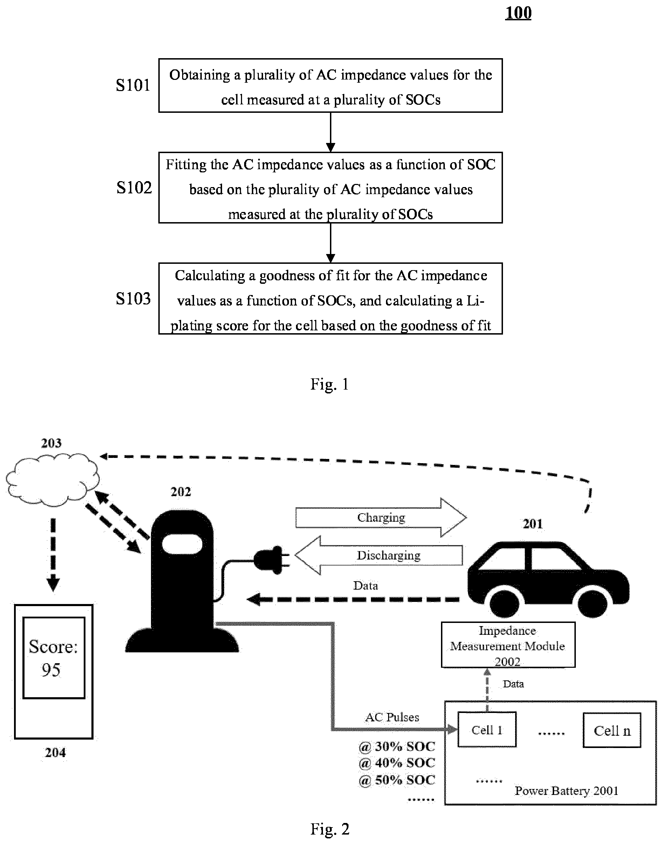

Fig. 1 shows a flowchart of a method for Li-plating detection of a cell of a power battery according to an embodiment of the present disclosure. As shown in Fig. 1, an example method 100 of the present disclosure may include steps as follows:

At Step S101, obtaining a plurality of AC impedance values for the cell measured at a plurality of SOCs, in which the plurality of AC impedance values are measured in a non-driving state of a vehicle.

Specifically, the non-driving state of the vehicle may include: the vehicle being charged, the vehicle being discharged to an energy storage system (such as V2G), or the vehicle being parked with the engine off. In the non-driving state, the vehicle will not charge or discharge the cell of the power battery due to behaviors during the driving, so when the AC impedance values of the cell are measured in such a non-driving state, basically the corresponding SOCs will not change, which can guarantee the accuracy of the measured AC impedance values.

Additionally, according to an embodiment of the present disclosure, it is possible to choose to measure the AC impedance values of the cell at SOCs at specific time intervals (e.g., every 10 minutes during the charging/discharging), or choose to measure the AC impedance values of the cell at specific levels of SOCs (e.g., 30%, 40%, ..., 80%), and depending on the specific needs for data fitting, for example, the AC impedance values of the cell can be measured at five or more discrete SOCs, in which each measured SOC is distributed as uniformly as possible in a range with a larger span (e.g., a range of at least more than 50% of the SOCs), resulting in a better result of data fitting. In addition, it is also possible to determine the specific number of SOCs that are used to measure the AC impedance values of the cell by weighing factors such as the amount of calculation for data, storage cost, and performance requirement.

Additionally, the measurement of the AC impedance values of the cell may be performed by a corresponding module in the vehicle, which, for example, may be done by an impedance measurement module of a Battery Management System (BMS) of the vehicle, or by other device(s) outside the vehicle (e.g., energy exchange facility) or a corresponding module therein. The plurality of AC impedance values measured in the non-driving state of the vehicle together with the corresponding SOCs are recorded in a storage medium, and are obtained by an entity that is to perform the Li-plating detection, for the subsequent processing of the Li-plating detection. For example, the measured plurality of AC impedance values may be provided to a data analysis system that is located in the cloud or a similar external server, for the data analysis system to perform the subsequent processing such as the data fitting based on the plurality of AC impedance values and the calculation of the Li-plating score.

At Step S102, fitting the AC impedance values as a function of SOC based on the plurality of AC impedance values measured at the plurality of SOCs.

Typically, an AC impedance value of a cell may be expressed as a complex number, that is, the plurality of AC impedance values measured at the plurality of SOCs may include impedance values with a real part and an imaginary part that correspond to different values of SOCs. Since the real part of a complex number can better embody the actual significance of a physical quantity, it is required to fit a relationship between the real parts of the AC impedance values and the SOCs. Specifically, firstly an appropriate function for fitting is selected as a mathematical model that describes the relationship between the AC impedance values and the SOCs. For example, according to an embodiment of the present disclosure, the AC impedance values as a function of SOC may be expressed as a formula as follows:

$$y_{impedance-real} = \frac{\alpha}{\sqrt{\beta_2 x_{soc}^2 + \beta_1 x_{soc} + \beta_0}}$$

where $y_{impedance-real}$ is the real part of the AC impedance value of the cell, $x_{soc}$ is the value of the SOC, and $\alpha$, $\beta_0$, $\beta_1$ and $\beta_2$ are the model parameters of the function. The above function and model parameters are only an exemplary embodiment of the present disclosure. It can be understood that other function, such as linear function, nonlinear function, or exponential function can also serve as the mathematical model that describes the relationship between the AC impedance values and the SOCs. After the mathematical model is determined, with a fitting algorithm such as least square method, maximum likelihood estimation method, and the like, the values of respective model parameters $\alpha$, $\beta_0$, $\beta_1$ and $\beta_2$ in the above function may be solved based on the existing plurality of AC impedance values measured at the plurality of SOCs, such that the AC impedance values as a function of SOC are derived, that is, $y_{impedance-real} = f(x_{soc})$.

At Step S103, calculating a goodness of fit for the AC impedance values as a function of SOC, and calculating a Li-plating score for the cell based on the goodness of fit.

As described above, data fitting is to determine, through a limited amount of known data (such as measured values), an optimal function model that can describe a relationship between data. This model is intended to enable any unknown data to conform to the function model as much as possible. As used herein, the goodness of fit can broadly refer to a metric representing a difference between fitted values and true values, so the goodness of fit is typically used to measure the effectiveness and reliability of the fitted model. For example, commonly used goodness of fit may include metrics such as residual sum of squares, root mean square error, or mean square error. According to an embodiment of the present disclosure, the goodness of fit for the AC impedance values as a function of SOC may employ the algorithm of residual sum of squares, which is expressed as a formula as follows:

$$R^2 = \frac{SSR}{SST} = \frac{\sum_{i=1}^{n}(\hat{y}_i - \bar{y})^2}{\sum_{i=1}^{n}(y_i - \bar{y})^2} = 1 - \frac{\sum_{i=1}^{n}(y_i - \hat{y})^2}{\sum_{i=1}^{n}(\hat{y}_i - \bar{y})^2}$$

where $R^2$ is the goodness of fit for the function, the denominator, i.e., SST (Total Sum of Squares), represents a sum of squares of the differences between the true values $y_i$ (which are the real parts of the AC impedance values of the cell in this embodiment) and the average $\bar{y}$ of the true values, and the numerator, i.e., SSR (Regression Sum of Squares) represents a sum of squares of the differences between the fitted values $\hat{y}_i$ and the average $\bar{y}$ of the true values. In this embodiment, the true values $y_i$ are the real parts of the AC impedance values of the cell measured at n SOCs, and the fitted value $\hat{y}_i$ is a predicted value calculated by substituting the value of SOC as an argument into the function as fitted above. Therefore, in this embodiment, the value of goodness of fit is between 0 and 1. The closer this value is to 1, the closer the fitted value of the function is to the actually measured AC impedance value. Conversely, the closer this value is to 0, the more the fitted value of the function deviates from the actually measured AC impedance value. For example, the true values $y_i$ respectively measured at 30%, 40%, 50%, 60% and 80% are 0.0014, 0.0015, 0.0016, 0.0018 and 0.0019, respectively. Through the fitted function derived based on these true values, the fitted values $\hat{y}_i$ calculated at these SOCs are 0.0016, 0.0015, 0.0016, 0.0017, and 0.0019, respectively. Based on these true values $y_i$ together with their corresponding fitted values $\hat{y}_i$, the goodness of fit for the function can be calculated to be about 0.737.

As described above, it has been recognized in the present disclosure that the actual impedance of a cell will be affected by the Li-plating phenomenon. Specifically, for a cell in which Li-plating occurs, the actual impedance of the cell will seriously deviate from its corresponding fitted value in some sections of SOC (e.g., in a low SOC section). The higher the degree of Li-plating is, the greater the difference between the true value of the impedance of the cell and the fitted value of the impedance, and correspondingly, such a difference will be reflected in the decrease in the goodness of fit for the function. Conversely, for a cell in which no Li-plating occurs, the relationship between its AC impedance values and the SOCs can be well reflected by the function, that is, as compared with the case where no Li-plating occurs, the goodness of fit for the function fitted with respect to the AC impedance value of the cell in which Li-plating occurs is lower. The more serious the degree to which Li-plating occurs in the cell, the lower the goodness of fit is. Therefore, based on such an association, the goodness of fit for the AC impedance values as a function of SOC may be used to calculate the Li-plating score indicating the degree to which Li-plating occurs in the cell. For example, according to an embodiment of the present disclosure, the value of goodness of fit in the above example may be expressed as a percentage ($\times$100%) as the Li-plating score for the cell, or the value of goodness of fit that falls within the corresponding section may be mapped as a fixed score or a qualitative rating (excellent, good, poor).

It can be seen that the Li-plating score for the cell calculated based on the goodness of fit can quantify the degree to which Li-plating occurs in the cell. For example, in this embodiment, the higher the Li-plating score is, the lower the degree to which Li-plating occurs in the cell is (or the lower the possibility that Li-plating occurs is), or otherwise in the opposite case, the higher the degree to which Li-plating occurs in the cell is. On this basis, the Li-plating score can be further compared with a specific threshold, giving a qualitative decision of whether Li-plating occurs in a specific cell.

Additionally, the above method is described with respect to a single cell of a power battery, that is, the method for Li-plating detection of the embodiments of the present disclosure is the Li-plating detection with respect to the cell level. This is because the Li-plating detection of the power battery should follow the "Cask Theory", that is, the service life and safety of the entire power battery will be compromised if Li-plating occurs in any cell in the power battery. Therefore, whether Li-plating occurs in the power battery should depend on the degree to which Li-plating occurs in every cell therein. As such, it can be understood that the Li-plating detection with respect to the power battery level can be implemented by performing the method for Li-plating detection of the present disclosure for each cell in the power battery.

In conjunction with Fig. 1 above, the overall flow of the method for Li-plating detection of a cell of a power battery is described through various exemplary embodiments. Through the above method, a score indicating a degree to which Li-plating occurs in the cell can be calculated, in a relatively simple manner, by utilizing impedance data measured in a non-driving state of a vehicle. Also, a more accurate result of Li-plating detection can be derived by measuring impedance values only at a plurality of discrete SOCs, without requiring a thorough charging and discharging of the battery or a complete charging and discharging characteristic curve. Therefore, a method for Li-plating detection with wide applicability and simple calculation is implemented.

Fig. 2 shows an example scenario for Li-plating detection according to an embodiment of the present disclosure. Specifically, in this scenario, a vehicle 201 is being charged through an energy exchange facility 202 (such as a charging pile, discharging pile, or multifunctional pile integrated with charging and discharging functionalities), or being discharged to an energy storage system (e.g., V2G). In this case, in order to increase the number of data for fitting the AC impedance value as a function of SOC, the AC impedance values at different frequencies may be derived by intermittent impedance measurement during charging/discharging, facilitating better data fitting of the AC impedance values, in turn detecting more accurately whether Li-plating occurs in the cell. According to an embodiment of the present disclosure, a plurality of AC pulses with different frequencies may be provided by the energy exchange facility 202 for offering charging or discharging of the vehicle.

Specifically, during the charging/discharging of the vehicle, the charging/discharging is suspended at different SOCs (e.g., 30%, 40%, ..., 80%), and a plurality of AC pulses with different frequencies are applied to the cell of the power battery. For example, taking a charging scenario as an example, when the energy exchange facility 202 charges a power battery 2001 of the vehicle 201 to a SOC level of 30%, the charging of the vehicle is suspended, and 3 sine-wave AC pulses with a magnitude of 15mV and with frequencies of 0.01Hz, 0.1Hz and 1Hz respectively are applied to a cell (e.g., Cell 1) of the power battery, in which each AC pulse can last for several seconds, such that an impedance measurement module 2002 of the vehicle 201 can acquire the voltage changes and current changes for the cell, that is, the response by the cell to the plurality of AC pulses. According to this, the AC impedance values at respective frequencies corresponding to the SOC level of 30% are calculated. After the plurality of AC pulses are applied, the charging of the power battery is restarted, and the charging is suspended when a SOC level of 40% is reached. A plurality of the same AC pulses are applied to the cell, and the AC impedance values at the respective frequencies corresponding to the SOC level of 40% are calculated. The above process is repeated more than once, until the AC impedance values measured at a sufficient number of SOCs are obtained, and the AC impedance values at the above 3 frequencies are included at each SOC.

According to an embodiment of the present disclosure, these AC impedance values may be transferred from the vehicle 201 to the energy exchange facility 202 and further transferred to the cloud 203 by the energy exchange facility 202 (e.g., the data analysis system that is located in the cloud as described above), or may be directly transferred to the cloud 203 by the vehicle 201, such that the method described above according to the present disclosure can be performed at the cloud 203, including: fitting the AC impedance values as a function of SOC based on the obtained plurality of AC impedance values; and calculating a goodness of fit for the function, and calculating a Li-plating score for the cell based on the goodness of fit. In this embodiment, the AC impedance values at the above 3 frequencies are included at each SOC, so the AC impedance values corresponding to the same frequency can be used for data fitting, and 3 corresponding functions can be fitted respectively. For example, from a SOC of 30% to a SOC of 80%, if the AC pulses with the above 3 frequencies are applied to every 10% of SOC, a total of $3 \times 6 = 18$ AC impedance values can be measured at 6 SOC levels. On this basis, with the data fitting method as described above, the AC impedance values corresponding to the frequency of 0.01Hz at 6 SOC levels can be fitted as a function of SOC, $y_{0.01Hz} = f(x_{soc})$. In a similar way, the AC impedance values corresponding to the other two frequencies (0.1Hz and 1Hz) can be fitted as functions of SOCs, $y_{0.1Hz} = f(x_{soc})$ and $y_{1Hz} = f(x_{soc})$.

Then, for a function fitted based on the AC impedance values measured under each AC pulse, a goodness of fit for a function corresponding to each AC pulse is calculated. For example, with the algorithm for goodness of fit as described above, the goodness of fit $R^2_{0.01Hz}$ for the function $y_{0.01}$ corresponding to the AC pulse with a frequency of 0.01Hz, the goodness of fit $R^2_{0.1Hz}$ for the function $y_{0.1}$ corresponding to the AC pulse with a frequency of 0.1Hz, and the goodness of fit $R^2_{1Hz}$ for the function $y_1$ corresponding to the AC pulse with a frequency of 1Hz can be calculated, respectively, and the Li-plating score for the power battery can be calculated based on the goodness of fit ( $R^2_{0.01Hz}$, $R^2_{0.1Hz}$ and $R^2_{1Hz}$ ) of the functions corresponding to respective AC pulses. For example, weights may be assigned to the goodness of fit for the functions corresponding to each AC pulse, and the Li-plating score for the cell can be calculated by weighting respective goodness of fit, or the AC impedance values at different frequencies can be comprehensively considered by combining the goodness of fit for the functions corresponding to respective AC pulses into a fusion algorithm. The calculated Li-plating score can directly indicate, in a quantized manner, a degree to which Li-plating occurs in a specific cell, or can be further compared with a predetermined threshold, to give a rating or a risk that Li-plating occurs (e.g., low, medium, and high) to a specific cell or power battery. For example, as shown in Fig. 2, the Li-plating score calculated by the cloud 203 may be provided to a user terminal 204 and presented to a user in a visualized manner, or may be provided to the energy exchange facility 202 and presented to the user by the energy exchange facility 202, or may be used to perform other actions or strategies.

It can be seen that the method for Li-plating detection of the present disclosure can be applicable to a scenario of vehicle's charging/discharging. By obtaining the AC impedance values at different frequencies by providing AC pulses intermittently during the charging/discharging of the vehicle, the effect of data fitting of AC impedance values can be further improved with barely affecting the user's experience, and in turn, the accuracy of Li-plating detection can be improved.

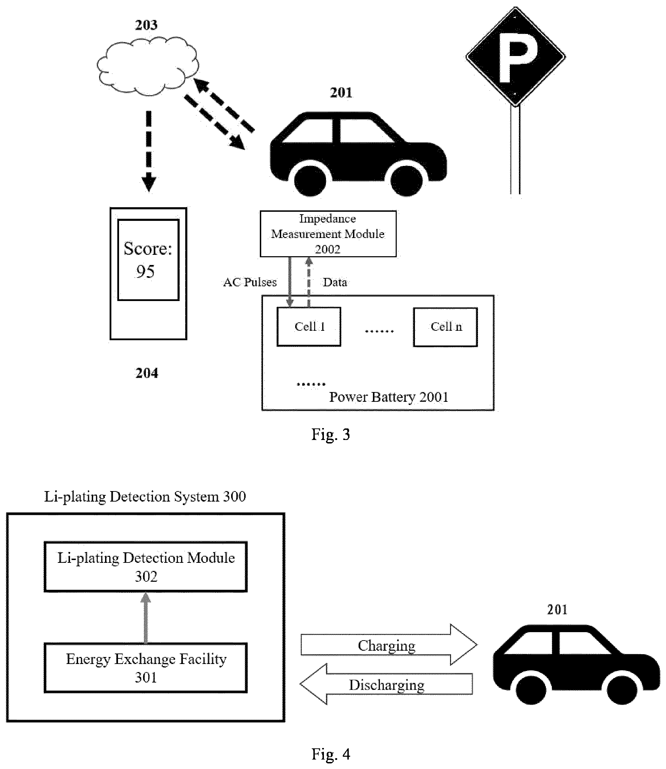

Fig. 3 shows another example scenario for Li-plating detection according to an embodiment of the present disclosure. Specifically, in this scenario, the vehicle 201 is parked and the engine is shut off. In this case, similar to the embodiment of Fig. 2, a plurality of AC pulses with different frequencies may be applied to a cell when the vehicle is being parked with engine off. According to an embodiment of the present disclosure, the plurality of AC pulses with different frequencies may be provided by the impedance measurement module 2002 (e.g., which may be integrated in the BMS of the vehicle) inside the vehicle.

Specifically, for example, the user arrives at the company for work at 9:00 am on Monday, shuts down and parks the vehicle 201, and the current SOC is 83%, then at the current SOC, 3 sine-wave AC pulses with a magnitude of 15mV and with frequencies of 0.01Hz, 0.1Hz and 1Hz respectively are applied to a cell (e.g., Cell 1) of the power battery, in which each AC pulse can last for several seconds, such that the impedance measurement module 2002 of the vehicle 201 can acquire the voltage changes and current changes for the cell, that is, the response by the cell to the plurality of AC pulses. According to this, the AC impedance values at respective frequencies corresponding to the SOC level of 83% are calculated. Afterwards, the user returns home at 8:00 pm on Monday, and shuts down and parks the vehicle 201 again, and the current SOC is 74%, then at the current SOC, a plurality of the same AC pulses are applied, and the AC impedance values at respective frequencies corresponding to the SOC level of 74% are calculated. Afterwards, the user arrived at the suburb at 11:00 am on Tuesday, shuts down and parks the vehicle 201, and the current SOC is 54%, then at the current SOC, a plurality of the same AC pulses are applied, and the AC impedance values at respective frequencies corresponding to the SOC level of 54% are calculated. Afterwards, the user might charge the vehicle briefly on Wednesday, return home at 11:00 am, and shut down and park the vehicle 201, and the current SOC is 66%, then at the current SOC, a plurality of the same AC pulses are applied, and the AC impedance values at respective frequencies corresponding to the SOC level of 66% are calculated. It can be seen that, for example, in a period shorter than one week, the vehicle might be parked more than once at different times and dates, and the SOC may be different each time the vehicle is parked. Therefore, similar to the embodiment of Fig. 2, in this embodiment, the AC impedance values measured at a sufficient number of SOCs can also be obtained, and the AC impedance values at the above 3 frequencies are included at each SOC.

Additionally, considering that the vehicle might be parked in entirely different locations and weather conditions, thus there is a larger difference between the ambient temperature and the cell temperature during the measurement of AC impedance values, and the temperature will change the impedance characteristics of the cell, which in turn affects the changing trend of the AC impedance value with the SOC. Therefore, if data fitting is performed on the AC impedance values measured at different temperatures, the accuracy of fitting will be affected. Additionally, there will be an energy attenuation in the power battery as the service time increases. Similarly, the impedance characteristics of the cell in different attenuation stages will vary with the service time of the battery. Therefore, using the impedance data with too long time intervals to perform fitting will also affect the accuracy of fitting. In order to avoid a decrease in the accuracy of fitting, it is required to screen the AC impedance values for data fitting. According to an embodiment of the present disclosure, based on additional parameters, a first subset corresponding to a specific range of the additional parameters is selected from the measured plurality of AC impedance values, and the AC impedance values are fitted as a function of SOC based on the first subset of the measured plurality of AC impedance values, in which the additional parameters may include: ambient temperature at the measurement, cell temperature at the measurement, and measurement time (such as a date or a more specific time at the measurement). For example, the data corresponding to the ambient temperature (or cell temperature) of 20 to 25 degrees Celsius may be selected from all the measured plurality of AC impedance values. Additionally or alternatively, the data corresponding to a specific period (e.g., one week) may be selected as the AC impedance values for data fitting, thereby avoiding using the AC impedance values based on cell conditions with greater differences for fitting.

In addition, as shown in Fig. 3, the AC impedance values for data fitting may be directly transferred from the vehicle 201 to the cloud 203, such that the method described above according to the present disclosure can be performed at the cloud 203, which is similar to what is described above in conjunction with Figs. 1 and 2. Additionally, the Li-plating score calculated by the cloud 203 may be provided to the user terminal 204 and presented to the user in a visualized manner, or may be directly provided to the vehicle 201 and presented to the user through a display device (e.g., on-board screen) in the vehicle 201, or may be used to perform other actions or strategies.

It can be seen that the method for Li-plating detection of the present disclosure can also be applicable to a daily scenario where the vehicle is parked. By obtaining the AC impedance values at different frequencies by providing AC pulses at different SOCs during an idle period during which the user does not use the vehicle, the effect of data fitting of AC impedance values can be further improved, and in turn, the accuracy of Li-plating detection can be further improved, with barely affecting the user's experience.

Two typical application scenarios of the method for Li-plating detection according to the embodiments of the present disclosure are described above in conjunction with Figs. 2 and 3, respectively.

Additionally, in the above embodiments, the frequency and magnitude of the AC pulse and the type of the pulse are only examples, and other AC pulses may be selected depending on specific applications. Additionally, only the elements and signal flows having a higher correlation with the content describing the embodiments are schematically shown in Figs. 2 and 3 above. For example, it is only shown that AC pulses are applied to Cell 1 in the power battery 2001. It can be understood that AC pulses can also be applied to any number of cells in the power battery 2001 and the corresponding Li-plating detection can be performed. Additionally, in the above embodiment, the processing of performing data fitting and calculating Li-plating scores are performed at the cloud 203. According to other embodiments of the present disclosure, at least some of such processing can also be performed at the vehicle 201 or the energy exchange facility 202, or may be accomplished by a cooperation of different entities in the system, and various entities in the system may communicate with each other.

Fig. 4 shows a block diagram of a system for Li-plating detection of a cell of a power battery according to an embodiment of the present disclosure.

As shown in Fig. 4, the present disclosure provides a Li-plating detection system 300. The system 300 includes: an energy exchange facility 301, for providing charging and/or discharging services to the vehicle 201; and a Li-plating detection module 302, for detecting whether Li-plating occurs in a cell of a power battery. For example, the energy exchange facility 202 described above can be taken as an example of the energy exchange facility 301 of the Li-plating detection system 300, and the cloud 203 described above or the data analysis system that is located in the cloud can be taken as an example of the Li-plating detection module 302 of the Li-plating detection system 300. The Li-plating detection module 302 may be integrated in the energy exchange facility 301 to function as its internal module, or the Li-plating detection module 302 and the energy exchange facility 301 may be integrated in the same apparatus, in which case the Li-plating detection module and the energy exchange facility may communicate through an internal bus. Alternatively, the Li-plating detection module 302 may be geographically separated from the energy exchange facility 301, in which case the Li-plating detection module may communicate with the energy exchange facility in a wired or wireless manner.

Specifically, the energy exchange facility 301 is configured to: suspend, during the charging or discharging of the vehicle, the charging/discharging at different States of Charge (SOCs); and as described above, apply a plurality of AC pulses with different frequencies to the cell, and provide a plurality of AC impedance values measured at the plurality of SOCs to the Li-plating detection module, in which the plurality of AC impedance values are calculated, at each of the plurality of SOCs, according to a response by the cell to the plurality of AC pulses, which, for example, may be done by the impedance measurement module of the BMS inside the vehicle, or by the energy exchange facility itself, which is not limited here. Additionally, the Li-plating detection module 302 is configured to: fit the AC impedance values as a function of SOC based on the received plurality of AC impedance values; and calculate a goodness of fit for the function, and calculate a Li-plating score for the cell based on the goodness of fit, in which the Li-plating score can be used to indicate a degree to which Li-plating occurs in the cell. The specific method for Li-plating detection is the same as what is described above, which will not be detailed here.

It can be seen that the Li-plating detection system according to the embodiment of the present disclosure can not only provide charging/discharging services to the vehicle, but also incidentally detect, while charging/discharging the vehicle, whether Li-plating occurs in the cell of the current power battery of the vehicle. Therefore, a multifunctional energy exchange station can be realized. For example, such a multifunctional energy exchange station can be applied to sites that can provide various services to the vehicle, such as a charging station of a electric vehicle or maintenance center.

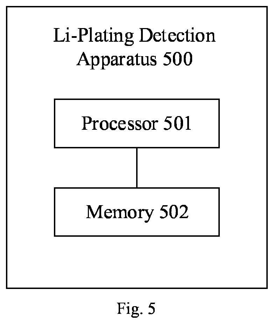

Fig. 5 is a block diagram showing an apparatus for Li-plating detection of a cell of a power battery according to an embodiment of the present disclosure.

As shown in Fig. 5, an apparatus 500 for Li-plating detection of a cell of a power battery includes: a processor 501 and a memory 502. The apparatus 500 may be a computer or a remote server that is integrated in a vehicle. It should be understood that the shown structure is only exemplary rather than limitation, and in addition to such units, the apparatus 500 may include other components. However, since such components are irrelevant to the contents of the embodiments of the present disclosure, the illustrations and descriptions thereof are omitted herein.

In addition, since the specific details of the operations performed by the apparatus 500 for Li-plating detection of a cell of a power battery according to the embodiment of the present disclosure are substantially the same as those described hereinbefore, part of the description of the same details is omitted herein for purpose of brevity.

The processor 501 may be a central processing unit (CPU), a micro-control unit (MCU), a data signal processor (DSP), or a processing unit in other form with data processing capability and/or instruction executing capability, and may utilize computer program instructions stored in the memory 502 to perform desired functionalities, in which the computer program instructions, when executed by the processor 501, cause the apparatus 500 to perform the operations for Li-plating detection of a cell of a power battery as follows: obtaining a plurality of AC impedance values for the cell measured at a plurality of SOCs: fitting the AC impedance values as a function of SOC based on the plurality of AC impedance values; and calculating a goodness of fit for the fitted function, and calculating a Li-plating score for the cell based on the goodness of fit. The plurality of AC impedance values are measured in a non-driving state of the vehicle, and the non-driving state includes: the vehicle being charged, the vehicle being discharged to an energy storage system, or the vehicle being parked with engine off. Preferably, the plurality of SOCs are uniformly distributed in a range spanning at least 50% of the SOCs, and/or the number of the plurality of SOCs is greater than or equal to 5.

Additionally, the computer program instructions, when executed by the processor 501, cause the apparatus 500 to further perform the operations as follows:

Suspending, during the charging/discharging of the vehicle, the charging/discharging at the plurality of different SOCs, and applying a plurality of AC pulses with different frequencies to the cell; and alternatively, applying, when the vehicle is parked with engine off, the plurality of AC pulses with different frequencies to the cell at the plurality of different SOCs, in which the plurality of SOCs correspond to the SOCs when the vehicle is parked at different times, and calculating, at each of the plurality of SOCs, the AC impedance values at corresponding frequencies according to a response by the cell to the plurality of AC pulses. Calculating, for a function fitted based on the AC impedance values measured under each AC pulse, a goodness of fit for the function corresponding to each AC pulse; and calculating a Li-plating score for the cell based on the goodness of fit for the function corresponding to each AC pulse. Additionally, for the case that the plurality of AC impedance values are measured in the non-driving state in which the vehicle is parked with engine off, selecting, based on additional parameters, a first subset corresponding to a specific range of the additional parameters from the measured plurality of AC impedance values, and fitting the AC impedance values as a function of SOC based on the first subset, in which the additional parameters include: ambient temperature at the measurement, cell temperature at the measurement, and measurement time.

The memory 502 may include one or more computer program products, which may include various forms of computer-readable storage media, for example, volatile memory and/or nonvolatile memory. The one or more computer program instructions may be stored on the computer-readable storage medium, such that the processor 501 can execute the program instructions to implement the above functionalities of the embodiments as described above and/or other desired functionalities, and/or can perform the above methods according to embodiments of the present disclosure. Various applications and various data may also be stored in the computer-readable storage medium.

The present disclosure further provides a computer-readable storage medium having stored computer program instructions thereon, in which the computer program instructions, when executed by a processor, implement the steps performed by the processor as described above, which is consistent with corresponding contents of various embodiments as described above. In addition, it should be understood that various components or modules in the above apparatus can each be implemented by hardware, by software, or by a combination of hardware and software.

The method and apparatus for Li-plating detection of a cell of a power battery according to the embodiments of the present disclosure have been fully described above with reference to various accompanying drawings. Through various aspects and embodiments of the present disclosure, it is possible to perform a non-destructive Li-plating detection on the cell in a simple and accurate manner without affecting the user's use of the vehicle.

In addition, the basic principles of the present disclosure have been described above in conjunction with specific embodiments, but it should be noted that the benefits, advantages, effects, etc. as mentioned in the embodiments of the present disclosure are only examples rather than limitations, and such benefits, advantages, effects, etc. cannot be considered as essential to be possessed for various embodiments of the present disclosure. Additionally, the specific details as disclosed above are only for the purpose of illustration and easy understanding, rather than limitation, and the above details do not limit the present disclosure as having to be implemented with the above specific details.

The block diagrams of the devices, apparatuses, equipment, and systems as involved in the embodiments of the present disclosure are only illustrative examples, and are not intended to require or imply that they must be connected, arranged, or configured in the manner as shown in the block diagrams. As will be recognized by those skilled in the art, such devices, apparatuses, equipment, and systems may be connected, arranged, or configured in any manner. The words such as "comprise", "include" and "have" are open terms indicating "including but not limited to", and can be used interchangeably therewith. The wording "or" and "and" as used herein refer to the term of "and/or", and can be used interchangeably therewith, unless otherwise explicitly indicated in the context. The wording "such as" as used herein refers to the phrase "such as but not limited to", and can be used interchangeably therewith.

Additionally, as used herein, the "or" as used in an enumeration of items starting with "at least one of" indicates a separate enumeration, so that, for example, an enumeration of "at least one of A, B or C" means A or B or C, or AB or AC or BC, or ABC (i.e., A and B and C). In addition, the wording of "exemplary" does not mean that the described example is preferred or better than other examples.

It should also be noted that in the devices and methods of the present disclosure, various components or steps may be decomposed and/or recombined. Such decomposition and/or recombination should be regarded as equivalent solutions of the present disclosure.

For ordinary operators in the art, it can be understood that all or any part of the methods and devices of the present disclosure can be implemented in hardware, firmware, software or a combination thereof in any computing device (including a processor, a storage medium, etc.) or network of computing devices. The hardware can be a general-purpose processor, a digital signal processor (DSP), an ASIC, a field programmable gate array (FPGA) or other programmable logic device (PLD), discrete gate or transistor logic, discrete hardware assembly, or any combination thereof that is designed to perform the functionalities as described herein. The general-purpose processor can be a microprocessor, but as an alternative, the processor can be any commercially available processor, controller, microcontroller, or state machine. The processor can also be implemented as a combination of computing devices, e.g., a combination of a DSP and a microprocessor, a plurality of microprocessors, one or more microprocessors cooperating with a DSP core, or any other such configuration. The software can exist in a computer-readable tangible storage media in any form. By way of example and not limitation, such computer-readable tangible storage media may include RAM, ROM, EEPROM, CD-ROM or other optical disc storage, magnetic disc storage or other magnetic storage device, or any other tangible media that can be used to carry or store desired program codes in the form of instructions or data structures and that can be accessed by a computer. As used herein, disc includes compact disc (CD), laser disc, optical disc, digital versatile disc (DVD), floppy disc, and Blu-ray disc.

Various changes, substitutions, and alternations to the techniques as described herein can be made without departing from the taught techniques as defined by the appended claims. In addition, the scope of the claims of the present disclosure is not limited to the specific aspects of the processing, machines, manufacturing, composition of events, means, methods, and actions as described above. The processing, machines, manufacturing, composition of events, means, methods, or actions that currently exist or are to be developed later can be utilized to perform basically the same functionalities or achieve basically the same results as respective aspects described herein. As such, the appended claims include such as processes, machines, manufacture, composition of events, means, methods, or actions that are within the scope thereof.

The above description of the disclosed aspects is provided to enable any operator in the art to make or use the present disclosure. Various modifications to such aspects will be very obvious to those skilled in the art, and the general principles as defined herein can be applied to other aspects without departing from the scope of the present disclosure. Therefore, the present disclosure is not intended to be limited to the aspects as illustrated herein, but conforms to the widest scope consistent with the principles and novel features as disclosed herein.

The above description has been presented for purposes of illustration and description. In addition, this description is not intended to limit the embodiments of the present disclosure to the forms as disclosed herein. Although a plurality of example aspects and embodiments have been discussed above, those skilled in the art will recognize certain variations, modifications, changes, additions, and subcombinations thereof.

**Claims**

1. A computer-implemented method for Li-plating detection of a cell of a power battery (2001) of a vehicle (201), **characterized in that** the method comprises:

   obtaining a plurality of AC impedance values for the cell measured at a plurality of States of Charge (SOCs) (S 102), wherein the plurality of AC impedance values are measured in a non-driving state of the vehicle;
   fitting the AC impedance values as a function of SOC based on the plurality of AC impedance values (S103); and
   calculating a goodness of fit for the function, and calculating a Li-plating score for the cell based on the goodness of fit (S 104), wherein the Li-plating score indicates a degree to which Li-plating occurs in the cell.

2. The method according to claim 1, wherein the non-driving state includes:
   the vehicle being charged, the vehicle being discharged to an energy storage system, or the vehicle being parked with engine off.

3. The method according to claim 2, wherein the non-driving state is the vehicle being charged or being discharged to the energy storage system, and the obtaining the plurality of AC impedance values for the cell measured at the SOCs comprises:

   suspending, during the charging or discharging of the vehicle, the charging/discharging at the plurality of different SOCs, and applying a plurality of AC pulses with different frequencies to the cell; and
   calculating, at each of the plurality of SOCs, an AC impedance value at a corresponding frequency according to a response by the cell to the plurality of AC pulses.

4. The method according to claim 3, wherein the plurality of AC pulses with different frequencies are provided by an external facility for offering charging or discharging of the vehicle.

5. The method according to claim 2, wherein the non-driving state is the vehicle being parked with engine off, and the obtaining the plurality of AC impedance values for the cell measured at the SOCs comprises:

   applying, when the vehicle is parked with engine off, a plurality of AC pulses with different frequencies to the cell at the plurality of different SOCs, wherein the plurality of SOCs correspond to the SOCs when the vehicle is parked with engine off at different times; and
   calculating, at each of the plurality of SOCs, an AC impedance value at a corresponding frequency according to a response by the cell to the plurality of AC pulses.

6. The method according to claim 5, wherein the fitting the AC impedance values as a function of SOC based on the plurality of AC impedance values comprises:

   selecting, based on additional parameters, a first subset corresponding to a specific range of the additional parameters from the measured plurality of AC impedance values; and
   fitting, based on the first subset of the measured plurality of AC impedance values, the AC impedance values as a function of SOC,
   wherein the additional parameters include: ambient temperature at the measurement, cell temperature at the measurement, and measurement time.

7. The method according to any one of claims 3 to 6, wherein the calculating the goodness of fit for the function, and the calculating the Li-plating score for the cell based on the goodness of fit comprises:

calculating, for the function fitted based on the AC impedance values measured under each of the plurality of AC pulses, the goodness of fit for the function corresponding to each AC pulse; and
calculating the Li-plating score for the cell based on the goodness of fit for the function corresponding to each AC pulse.

8. The method according to any one claims 1 to 7, wherein the plurality of SOCs are uniformly distributed in a range spanning at least 50% of the SOCs, and/or the number of the plurality of SOCs is greater than or equal to 5.

9. An apparatus (500) for Li-plating detection of a cell of a power battery, the apparatus comprising:

a processor (501); and
a memory (502) having stored computer program instructions therein,
wherein the computer program instructions, when executed by the processor, cause the apparatus to perform the method for Li-plating detection of a cell of a power battery according to any one claims 1 to 8.

10. A computer-readable storage medium having stored thereon computer program instructions which, when executed by a processor of an apparatus for Li-plating detection of a cell of a power battery, cause the processor to perform the method for Li-plating detection of a cell of a power battery according to any one claims 1 to 8.

11. A system (300) for Li-plating detection of a cell of a power battery (2001) of a vehicle (201), comprising:

an energy exchange facility (301), configured to offer charging and/or discharging services to a vehicle; and
a Li-plating detection module (302), communicably connected with the energy exchange facility, and configured to:
obtain a plurality of AC impedance values for the cell measured at a plurality of States of Charge (SOCs), wherein the plurality of AC impedance values are measured when the energy exchange facility is offering the charging and/or discharging services;
fit the AC impedance values as a function of SOC based on the plurality of AC impedance values; and
calculate a goodness of fit for the function, and calculate a Li-plating score for the cell based on the goodness of fit, wherein the Li-plating score indicates a degree to which Li-plating occurs in the cell.

12. The system according to claim 11, wherein the energy exchange facility is configured to:

suspend, during the charging or discharging of the vehicle, the charging/discharging at different States of Charge (SOCs), and apply a plurality of AC pulses with different frequencies to the cell; and
provide a plurality of AC impedance values measured at the plurality of SOCs to the Li-plating detection module, wherein the plurality of AC impedance values are calculated, at each of the plurality of SOCs, according to a response by the cell to the plurality of AC pulses.

13. The system according to claim 11 or 12, wherein to calculate the goodness of fit for the function and to calculate the Li-plating score for the cell based on the goodness of fit, the Li-plating detection module is configured to:

calculate, for the function fitted based on the AC impedance values measured under each of the plurality of AC pulses, the goodness of fit for the function corresponding to each AC pulse; and
calculate the Li-plating score for the cell based on the goodness of fit for the function corresponding to each AC pulse.

14. The system according to any one claims 11 to 13, wherein the plurality of SOCs are uniformly distributed in a range spanning at least 50% of the SOCs, and/or the number of the plurality of SOCs is greater than or equal to 5.

15. A vehicle comprising:

a power battery (2001) including at least one cell; and
an impedance measuring module (2002) is configured to:

obtain a plurality of AC impedance values for one of the at least one cell measured at a plurality of States of Charge (SOCs), wherein the plurality of AC impedance values are measured in a non-driving state of the vehicle; and

provide the plurality of AC impedance values to an external apparatus (203, 204) for Li-plating detection of the cell of the power battery of the vehicle.

**100**

| S101 | Obtaining a plurality of AC impedance values for the cell measured at a plurality of SOCs |
|------|-----|

| S102 | Fitting the AC impedance values as a function of SOC based on the plurality of AC impedance values measured at the plurality of SOCs |
|------|-----|

| S103 | Calculating a goodness of fit for the AC impedance values as a function of SOCs, and calculating a Li-plating score for the cell based on the goodness of fit |
|------|-----|

Fig. 1

Fig. 2

203

201

Score:
95

Impedance
Measurement Module
2002

AC Pulses    Data

Cell 1    ......    Cell n

204

......
Power Battery 2001

Fig. 3

Li-plating Detection System 300

Li-plating Detection Module
302

Energy Exchange Facility
301

201

Charging

Discharging

Fig. 4

Li-Plating Detection
Apparatus 500

Processor 501

Memory 502

Fig. 5

Europäisches
Patentamt

European
Patent Office

Office européen
des brevets

## EUROPEAN SEARCH REPORT

**Application Number**

EP 25 16 5829

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WANG XUEYUAN ET AL: "Online Detection of Lithium Plating Onset for Lithium-Ion Batteries Based on Impedance Changing Trend Identification During Charging Processes", IEEE TRANSACTIONS ON TRANSPORTATION ELECTRIFICATION, IEEE, vol. 9, no. 2, 25 November 2022 (2022-11-25), pages 3487-3497, XP011943353, DOI: 10.1109/TTE.2022.3224965 [retrieved on 2022-11-28] | 1-5, 8-12,14, 15 | INV. G01R31/389 G01R31/392 |
| A | * the whole document * | 6,7,13 | |
| X | CN 112 394 289 A (UNIV TONGJI) 23 February 2021 (2021-02-23) | 15 | |
| A | * claim 1 * | 1-14 | |
| X | CN 117 347 878 A (UNIV TONGJI) 5 January 2024 (2024-01-05) | 15 | |
| A | * paragraph [0006]; claim 1 * | 1-14 | TECHNICAL FIELDS SEARCHED (IPC) |
| A | CN 117 192 405 A (INST ELECTRICAL ENG CAS) 8 December 2023 (2023-12-08) * claims 1,5 * | 1-15 | G01R H01M |

The present search report has been drawn up for all claims

| Place of search | Date of completion of the search | Examiner |
|---|---|---|
| Munich | 22 August 2025 | O'Callaghan, D |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 16 5829

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2025

| Patent document cited in search report | | Publication date | Patent family member(s) | Publication date |
|---|---|---|---|---|
| CN 112394289 | A | 23-02-2021 | NONE | |
| CN 117347878 | A | 05-01-2024 | NONE | |
| CN 117192405 | A | 08-12-2023 | NONE | |

EPO FORM P0459

For more details about this annex : see Official Journal of the European Patent Office, No. 12/82